# EUROPÄISCHE PATENTANMELDUNG

(11) **EP 1 345 486 A2**
(43) Veröffentlichungstag der Anmeldung: **17.09.2003**
(21) Anmeldenummer: 03005329.2
(22) Anmeldetag: 11.03.2003
(51) Int. Cl.: H05K 9/00

(54) **Gerätegehäuse mit leitfähig beschichteter Abschirmdichtung bzw.- wand**

(30) Priorität: 11.03.2002 DE 10210577
(71) Anmelder: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Heinze, Ekkehard, Dipl.-Phys. Dr.

(57) **Zusammenfassung**

Gerätegehäuse mit leitfähig beschichteter Abschirmdichtung bzw. -wand, wobei die leitfähige Beschichtung als Dünnschicht aus Zinn bzw. einer Zinnlegierung ausgebildet ist.

## Beschreibung

Die Erfindung betrifft ein Gerätegehäuse eines elektronischen Gerätes mit mindestens einer leitfähig beschichteten Abschirmdichtung bzw. -wand, wie es beispielsweise massenhaft als Telekommunikations-Endgerät (speziell Mobiltelefon) gefertigt und eingesetzt wird.

Zur Herstellung der elektromagnetisch abschirmend wirkenden Dichtungen derartiger Geräte sind verschiedene Techniken bekannt, von denen in jüngerer Zeit die sogenannte Dispens-Technik, d.h. das Auftragen eines Dichtmaterials im pastösen Zustand mittels einer computergesteuert geführten Austragnadel oder -düse mit anschließendem Aushärten, besondere Verbreitung erlangt hat. Daneben sind aber auch Abschirmdichtungen bekannt, die mittels eines auf ein entsprechendes Gehäuseteil aufgesetzten Formwerkzeuges und Einspritzen des flüssigen oder pastösen Dichtungsmaterials in das Formwerkzeug (normalerweise bei erhöhter Temperatur) gebildet werden. Bekannt sind ferner als Endlosprofile vorgefertigte (extrudierte) Dichtungen, die insbesondere an Gehäuse-Außenkanten und speziell unter Einpassung in dort vorgesehene Nuten angebracht werden.

Um den in Rede stehenden Dichtungen die zur Erzeugung der benötigten EMI-Abschirmwirkung erforderliche Leitfähigkeit zu verleihen, sind ebenfalls verschiedene Techniken bekannt.

Besonders verbreitet ist die Beimengung von leitfähigem Material (insbesondere Metall, aber auch Kohlenstoff o.ä.) mit geringer Teilchengröße zur flüssigen oder pastösen Dichtungsmasse in einem Anteil, der eine ausreichende Volumen-Leitfähigkeit der Masse sichert. Dieses Vorgehen hat allerdings die Nachteile eines relativ hohen Verbrauches an leitfähigem Material und der Notwendigkeit, einen Kompromiss zwischen einem hohen Füllungsgrad zur Erzielung vorteilhafter EMI-Abschirmeigenschaften einerseits und einer möglichst geringen Beeinträchtigung der Elastizitäts- bzw. Kompressibilitätsparameter des Ausgangsmaterials zu finden. Daneben gibt es Sedimentationsprobleme, die die Brauchbarkeit der auf diese Weise leitfähig gefüllten Abschirmmaterialien für bestimmte Anwendungen beeinträchtigen können.

Als alternatives Verfahren ist daneben die nachträgliche leitfähige Beschichtung einer aus einem reinen Dichtungsmaterial gebildeten Dichtung bekannt. Diese Beschichtung kann sowohl mit einem weiteren, auf die oben beschriebene Weise leitfähig gefüllten Dichtungsmaterial - also als elastomere Deckschicht - wie auch als rein metallische Dünnschicht aufgebracht werden. Auch diesem Verfahren haften in seinen verschiedenen Ausführungsformen bestimmte Nachteile an, von denen hier für die erste Variante insbesondere die prinzipbedingt begrenzte Abschirmwirkung und für die zweite Variante die Anfälligkeit gegenüber Korrosion und mechanischer Beschädigung genannt seien.

Der Erfindung liegt die Aufgabe zugrunde, ein technologisch einfach und kostengünstig herstellbares Gerätegehäuse der oben genannten Art anzugeben, das den bestehenden Anforderungen an elektromagnetische Dichtigkeit bzw. Verträglichkeit (EMV) genügt.

Diese Aufgabe wird gemäß einem ersten Aspekt der Erfindung durch ein Gerätegehäuse mit den Merkmalen des Anspruchs 1 und gemäß einem zweiten, relativ unabhängigen Aspekt der Erfindung durch Geräte mit den Merkmalen des Anspruchs 7 oder 8 gelöst. Die abhängigen Ansprüche betreffen vorteilhafte Konkretisierungen der Erfindung.

Mit der vorgeschlagenen Lösung gemäß dem ersten Aspekt wird ein Gehäuse bereitgestellt, dessen EMI-Abschirmung auch unter hochgradig belastenden Umgebungsbedingungen, beispielsweise im Outdoor-Einsatz, in chemisch aggressiver Atmosphäre oder bei häufigem Öffnen und Wiederverschließen, eine hohe Beständigkeit aufweist. Zudem ist die Herstellung der Abschirmdichtung kostengünstig und technologisch einfach möglich, was zu insgesamt niedrigen Gestehungskosten des Gehäuses beiträgt.

In einer vorteilhaften Ausführung der Erfindung in diesem Sinne ist die eingesetzte Zinnlegierung eine Sn-/Pb-Legierung mit geringem Pb-Gehalt, insbesondere von weniger als 5 Masse-% Pb. Eine solche Zusammensetzung ist, abweichend von üblicherweise eingesetzten Lötzinn-Zusammensetzungen, sowohl im Hinblick auf die Leitfähigkeit als auch die mechanischen und Gebrauchswerteigenschaften, für eine EMI-Abschirmung besonders geeignet.

In einer etwas aufwendigeren, aber hinsichtlich der Abschirmeigenschaften besonders hochwertigen Ausführung hat die leitfähige Beschichtung einen Zweitschichtaufbau mit einer Basisschicht aus einem hoch leitfähigen Metall, insbesondere Kupfer oder einer Kupferlegierung, und der Dünnschicht aus Zinn bzw. der Zinnlegierung als Deckschicht. Hierbei verleiht die hochgradig leitfähige Basisschicht der Abschirmdichtung in vorteilhafter Weise einen niedrigen Oberflächenwiderstand, während die Deckschicht ihr vorteilhafte chemische und mechanische Eigenschaften verleiht.

In einer weiteren bevorzugten Ausführung hat die leitfähige Beschichtung eine Gesamtdicke im Bereich zwischen 0,5 µm und 10 µm. Obzwar für spezielle Anwendungen auch größere Schichtdicken sinnvoll sein können, lassen sich mit dem genannten Dickenbereich die erforderlichen EMI-Eigenschaften für Standardanwendungen bei relativ geringem Materialeinsatz und entsprechend niedrigen Kosten erzielen.

Eine weitere sinnvolle Ausführung der Erfindung sieht vor, dass die Abschirmdichtung bzw. -wand durch ein auf einen Träger aufdispensiertes Elastomeres gebildet ist. Dies ermöglicht ein vorteilhaftes Handling speziell von Abschirmdichtungen mit kleinen Querschnitten bei miniaturisierten elektronischen Geräten, bei gleichzeitig sehr guter mechanischer Beständigkeit des Dichtungsaufbaus.

Der Träger wird vielfach ein Gehäuseteil des Gerätes sein, welches zur Bildung eines geschlossenen Abschirmkäfigs selbst aus Metall besteht oder metallisch beschichtet ist, und die leitfähige Oberfläche der Abschirmdichtung wird im Kontakt mit einem weiteren, üblicherweise ebenfalls abschirmend wirkenden, Gehäuseteil stehen. Es ist aber auch möglich, dass der Träger - oder auch das gegenüberliegende, mit der Abschirmdichtung in Oberflächenkontakt stehende Geräteteil - ein Bauelementeträger (insbesondere eine Leiterplatte) ist.

Falls das Gehäuse eine gemäß der vorgeschlagenen Lösung beschichtete "Abschirmwand" aufweist, so ist diese in vorteilhafter Weise aus mehreren im wesentlichen übereinanderliegenden Strängen des Elastomeren oder einem einzelnen hohen Elastomerstrang, dessen Höhe mindestens das Doppelte der Breite beträgt, gebildet. Derartige Abschirmwände weisen die vorstehend für aufdispensierte Abschirmdichtungen genannten Vorteile auf. Zudem bietet das Verfahren der Unterteilung des Innenraumes eines Gerätegehäuses durch auf diese Weise gebildete Abschirmwände die Möglichkeit einfacher und schneller Konstruktionsänderungen, denn ein veränderter Gehäuseaufbau ist ohne Änderung von Werkzeugen im wesentlichen allein durch Umprogrammierung einer bekannten Dispensieranlage sowie der Einrichtung zum Aufbringen der vorgeschlagenen leitfähigen Beschichtung möglich.

Gemäß einem relativ selbstständigen Aspekt der Erfindung besteht die Abschirmdichtung bzw. -wand im wesentlichen aus einem thermoplastischen oder aber duroplastischen Polymeren. Derartige Polymere lassen sich durch geeignete Additive zur Beeinflussung der mechanischen Eigenschaften (Weichmacher etc.) in ihren Elastizitäts- bzw. Kompressionseigenschaften auf die konstruktionsbedingt benötigten mechanischen Dichtwirkungen anpassen und eignen sich gut als Träger für die vorgeschlagene abschirmende Beschichtung.

Besondere technologische Vorteile ergeben sich, wenn in einer bevorzugten Ausführungsform die Abschirmdichtung bzw. -wand, insbesondere stofflich zusammenhängend mit dem Träger, spritzgegossen ist. Hierdurch werden nämlich gesonderte Arbeitsgänge zur Erzeugung der Basisprofile der Abschirmdichtungen bzw. -wände entbehrlich, was die Gehäuseherstellung weiter verbilligt.

Soweit erforderlich, lassen sich die Abschirmwirkungen der Abschirmdichtungen bzw. -wände von Geräten der oben vorgeschlagenen Art weiter verbessern, wenn das Material der Abschirmdichtung bzw. -wand eine Füllung aus leitfähigem Material, insbesondere leitfähigen Metall- und/oder Kohlenstoffteilchen, aufweist - allerdings unter erhöhtem Einsatz von leitfähigem Material und mit entsprechender Kostensteigerung.

Die vorgeschlagene leitfähige Beschichtung mit Zinn oder einer Zinnlegierung lässt sich mit etablierten Vakuum-Beschichtungsverfahren, insbesondere als Vakuum-Aufdampfschicht oder Sputterschicht, in Großserie in hoher und gleichbleibender Qualität erzeugen. Alternativ ist die Ausführung als "klassische" Sprühbeschichtung (unter Atmosphärendruck erzeugt) möglich. Schließlich können auch weitere Beschichtungsverfahren zum Einsatz kommen, die für metallische oder metallhaltige Schichten etabliert sind, etwa galvanische oder Tauch-Verfahren.

Geräte der in Rede stehenden Art sind insbesondere Mobilfunk-Endgeräte oder andere Telekommunikations-Endgeräte oder Komponenten von Mobilfunknetzen (insbesondere Basisstationen), die eine Quelle von EMI bilden oder gegen solche empfindlich sind, oder auch EMI-störungsempfindliche Datenkommunikations- oder Datenverarbeitungsgeräte und Teile von solchen. Weiterhin kann es sich um Geräte aus den Gebieten der Sensorik, Betriebsmesstechnik und Prozesssteuertechnik, Funknavigationsgeräte o.ä. handeln.

Vorteile und Zweckmäßigkeiten der Erfindung ergeben sich im übrigen aus der nachfolgenden, lediglich skizzenhaften Beschreibung bevorzugter Ausführungsbeispiele und -aspekte. Von den Figuren zeigen:
- Fig. 1: eine schematische Querschnittsdarstellung eines Gerätegehäuses gemäß einer ersten Ausführungsform der Erfindung und
- Fig. 2: eine schematische Querschnittsdarstellung eines Gerätegehäuses gemäß einer zweiten Ausführungsform der Erfindung.

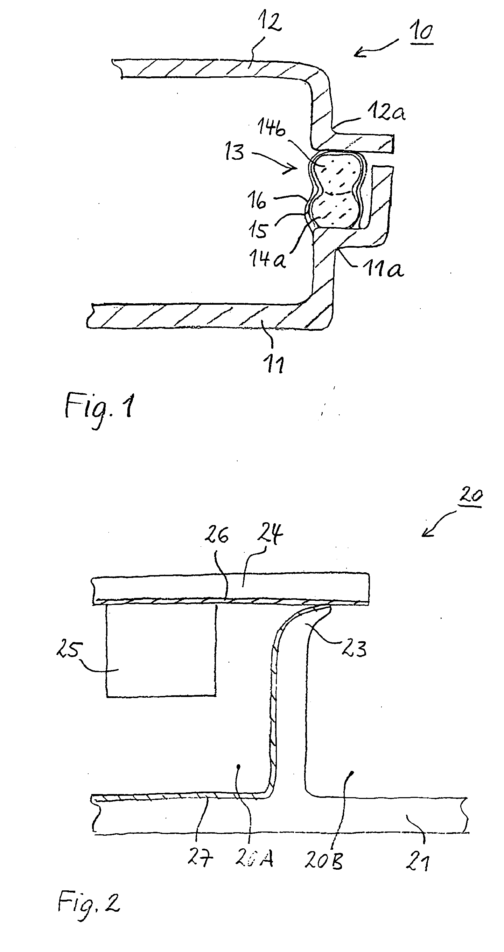

Fig. 1 zeigt einen Ausschnitt eines Gerätegehäuses 10 aus Metall, etwa aus tiefgezogenem Al-Blech, das eine untere Gehäuseschale 11 und eine obere Gehäuseschale 12 aufweist, die durch in der Figur nicht dargestellte Befestigungsmittel (beispielsweise Schrauben oder eine Rastverbindung) miteinander verbunden sind. In einem Kantenbereich des Gehäuses 10, in dem die untere und obere Gehäuseschale 11, 12 einen Abkantungsbereich 11a bzw. 12a aufweisen, ist zwischen beide eine abschirmende Gehäuseaußendichtung 13 eingefügt.

Die Gehäuseaußendichtung 13 ist aus zwei übereinander auf den Abkantungsbereich 11a der unteren Gehäuseschale 11 aufdispensierten Elastomersträngen 14a, 14b aufgebaut. Von diesen haftet der untere Elastomerstrang 14a fest auf der Oberfläche der unteren Gehäuseschale 11, und der obere Elastomerstrang 14b hat sich infolge seines Aufbringens unmittelbar nach der Bildung des unteren Elastomerstranges 14a materialeinheitlich mit diesem verbunden. Auf das hiermit gebildete Basis-Dichtprofil 14a/14b ist zunächst eine Kupfer-Dünnschicht als hochgradig leitfähige Basisschicht und hierauf eine Deckschicht 16 aus einer Zinnlegierung mit niedrigem Bleigehalt, jeweils in einem Hochvakuum-Beschichtungsverfahren, aufgebracht. Die Schichtdicken der Basisschicht 15 und der Deckschicht 16 sind zur Erzielung der geforderten Verformbarkeit der Gehäuseaußendichtung 13 einerseits und ihrer Abschirmwirkung andererseits festgelegt, wobei in Abhängigkeit vom Einsatzzweck des Gehäuses 10 auch die Beständigkeit gegenüber Umwelteinflüssen (Feuchtigkeit, Salzwasser o.ä.) zu beachten ist.

Fig. 2 zeigt schematisch in einer Querschnittsdarstellung einen Gehäuseabschnitt eines mittels Kunststoff-Spritzguss aus einem thermoplastischen Polymeren hergestellten Gehäuses 20, von dem nur ein unteres Gehäuseteil 21 mit einer senkrecht aufstehenden Trennwand 22 dargestellt ist. Die Trennwand 22 trennt einen gegen EMI abzuschirmenden ersten Gehäusebereich 20A mechanisch und elektromagnetisch dicht von einem zweiten Gehäusebereich 20B ab. Auf der Oberkante der Trennwand 22, die mit verjüngtem Querschnitt in Form einer biegeverformbaren Dichtlippe 23 ausgeführt ist, liegt eine Leiterplatte 24 mit elektronischen Komponenten auf, von denen symbolisch ein EMI-empfindliches Bauteil 25 dargestellt ist.

Nach oben ist der erste Gehäusebereich 20A elektromagnetisch durch eine leitende Oberflächenbeschichtung 26 der Leiterplatte 24 im wesentlichen dicht abgeschlossen. Nach unten und zur Seite hin wird die elektromagnetische Abschirmung durch eine auf den linken Abschnitt des unteren Gehäuseteils 21 und die sich hieran anschließende (linke) Oberfläche der Trennwand 22 ganzflächig aufgebrachte Zinnlegierungsschicht 27 gewährleistet.

Die Ausführung der Erfindung ist nicht auf diese Beispiele beschränkt, sondern ebenso in einer Vielzahl von Abwandlungen möglich, die im Rahmen fachgemäßen Handelns liegen. Insbesondere sind bei verschiedenartigen Gehäuseausführungen spritzgegossene und ggf. materialeinheitlich mit Gehäuseteilen geformte Abschirmwände mit aufdispensierten Abschirmdichtungen kombinierbar. Ebenso sind Abschirmdichtungen bzw. -wände mit einkomponentiger Dünnschicht auf Zinn-Basis in ein und demselben Gehäuse kombinierbar mit solchen, die eine zweikomponentige leitfähige Beschichtung aus einer Basisschicht (Cu, Ag o.ä.) und einer Zinn-Deckschicht aufweisen.

### Bezugszeichenliste

- 10; 20: Gehäuse
- 11; 21: untere Gehäuseschale
- 11a: Abkantung
- 12a: Abkantung
- 12: obere Gehäuseschale
- 13: Gehäuseaußendichtung (Abschirmdichtung)
- 14a, 14b: Elastomerstrang
- 14a/14b: Basis-Dichtprofil
- 15: Kupfer-Dünnschicht (Basisschicht)
- 16; 27: Zinnlegierungsschicht (Deckschicht)
- 20A, 20B: Gehäusebereich
- 22: Trennwand
- 23: Dichtlippe
- 24: Leiterplatte
- 25: Bauteil
- 26: Oberflächenbeschichtung

## Patentansprüche

1. Gerätegehäuse mit leitfähig beschichteter Abschirmdichtung bzw. -wand,
**dadurch gekennzeichnet, dass**
die leitfähige Beschichtung als Dünnschicht aus Zinn bzw. einer Zinnlegierung ausgebildet ist.

2. Gerätegehäuse nach Anspruch 1,
**dadurch gekennzeichnet, dass**
die Zinnlegierung eine Sn-/Pb-Legierung mit geringem Pb-Gehalt, insbesondere von weniger als 5 Masse-% Pb, ist.

3. Gerätegehäuse nach Anspruch 1 oder 2,
**dadurch gekennzeichnet, dass**
die leitfähige Beschichtung einen Zweitschichtaufbau mit einer Basisschicht aus einem hoch leitfähigen Metall, insbesondere Kupfer oder einer Kupferlegierung, und der Dünnschicht aus Zinn bzw. der Zinnlegierung als Deckschicht aufweist.

4. Gerätegehäuse nach einem der vorangehenden Ansprüche,
**dadurch gekennzeichnet, dass**
die leitfähige Beschichtung eine Gesamtdicke im Bereich zwischen 0,5 µm und 10 µm aufweist.

5. Gerätegehäuse nach einem der vorangehenden Ansprüche,
**dadurch gekennzeichnet, dass**
die Abschirmdichtung bzw. -wand durch ein auf einen Träger aufdispensiertes Elastomeres gebildet ist.

6. Gerätegehäuse nach Anspruch 5,
**dadurch gekennzeichnet, dass**
die Abschirmwand aus mehreren im wesentlichen übereinanderliegenden Strängen des Elastomeren oder einem einzelnen hohen Elastomerstrang, dessen Höhe mindestens das Doppelte der Breite beträgt, gebildet ist.

7. Gerätegehäuse mit leitfähig beschichteter Abschirmdichtung bzw. -wand, insbesondere nach einem der Ansprüche 1 bis 4,
**dadurch gekennzeichnet, dass**
die Abschirmdichtung bzw. -wand im wesentlichen aus einem thermoplastischen Polymeren besteht.

8. Gerätegehäuse mit leitfähig beschichteter Abschirmdichtung bzw. -wand, insbesondere nach einem der Ansprüche 1 bis 4,
**dadurch gekennzeichnet, dass**
die Abschirmdichtung bzw. -wand im wesentlichen aus einem duroplastischen Polymeren besteht.

9. Gerätegehäuse nach Anspruch 7 oder 8,
**dadurch gekennzeichnet, dass**
die Abschirmdichtung bzw. -wand, insbesondere stofflich zusammenhängend mit dem Träger, spritzgegossen ist.

10. Gerätegehäuse nach einem der vorangehenden Ansprüche,
**dadurch gekennzeichnet, dass**
das Material der Abschirmdichtung bzw. -wand eine Füllung aus leitfähigem Material, insbesondere leitfähigen Metallund/oder Kohlenstoffteilchen, aufweist.

11. Gerätegehäuse nach einem der vorangehenden Ansprüche,
**dadurch gekennzeichnet, dass**
die leitfähige Beschichtung oder mindestens die Deckschicht als Vakuum-Aufdampfschicht oder Sputterschicht ausgeführt ist.

12. Gerätegehäuse nach einem der Ansprüche 1 bis 10,
**dadurch gekennzeichnet, dass**
die leitfähige Beschichtung oder mindestens die Deckschicht als Sprühbeschichtung ausgeführt ist.

13. Gerät mit einem Gerätegehäuse.nach einem der vorangehenden Ansprüche,
**gekennzeichnet durch**
die Ausbildung als Tele- oder Datenkommunikationsgerät.
